# EUROPEAN PATENT SPECIFICATION

(11) **EP 1 658 636 B1**
(45) Date of publication and mention of the grant of the patent: **04.01.2012**
(21) Application number: 03818431.3
(22) Date of filing: 29.08.2003
(51) Int. Cl.: H01L 23/495, H01L 21/60

(54) **CHIP SUPPORT OF A LEAD FRAME FOR AN INTEGRATED CIRCUIT PACKAGE**
CHIP-TRÄGER EINES SYSTEMTRÄGERS FÜR EIN INTEGRIERTES SCHALTUNGS-GEHÄUSE
SUPPORT DE PUCE D'UNE GRILLE DE CONNEXION POUR UN BOITIER DE CIRCUIT INTEGRE

(43) Date of publication of application: 24.05.2006
(73) Proprietor: Infineon Technologies AG, 85579 Neubiberg (DE)
(72) Inventor: YAZID, Mohamad, B., Wagiman, Singapore 507566 (SG); LOW MIN WEE, Pauline, Singapore 670625 (SG)
(74) Representative: Howe, Steven
(86) International application number: PCT/SG2003/000201
(87) International publication number: WO 2005/022633

(56) References cited:
- EP-A- 0 546 435
- EP-A- 0 895 287
- US-B1- 6 342 730
- US-B1- 6 585 905
- PATENT ABSTRACTS OF JAPAN vol. 012, no. 489 (E-696), 21 December 1988 (1988-12-21) -& JP 63 202948 A (MITSUBISHI ELECTRIC CORP), 22 August 1988 (1988-08-22)
- PATENT ABSTRACTS OF JAPAN vol. 2002, no. 04, 4 August 2002 (2002-08-04) -& JP 2001 358279 A (SONY CORP), 26 December 2001 (2001-12-26)
- PATENT ABSTRACTS OF JAPAN vol. 007, no. 107 (E-174), 11 May 1983 (1983-05-11) -& JP 58 027353 A (TOKYO SHIBAURA DENKI KK), 18 February 1983 (1983-02-18)

## Description

### Field of the invention

The present invention relates to packaging integrated circuits, and in particular to how an integrated circuit can be packaged such that wire bonds can be reliably formed from certain contacts of the integrated circuit to a body which is at a ground potential. The invention provides packaging methods, lead frames for use in the method, and integrated circuit packages produced by the method.

### Background of Invention

The term integrated circuits as in this document refers to dies, usually consisting substantially of semiconductor material, having electrical contacts formed in their upper surface. During a packaging process, the dies are embedded in a resin body from which electrically conductive leads extend.

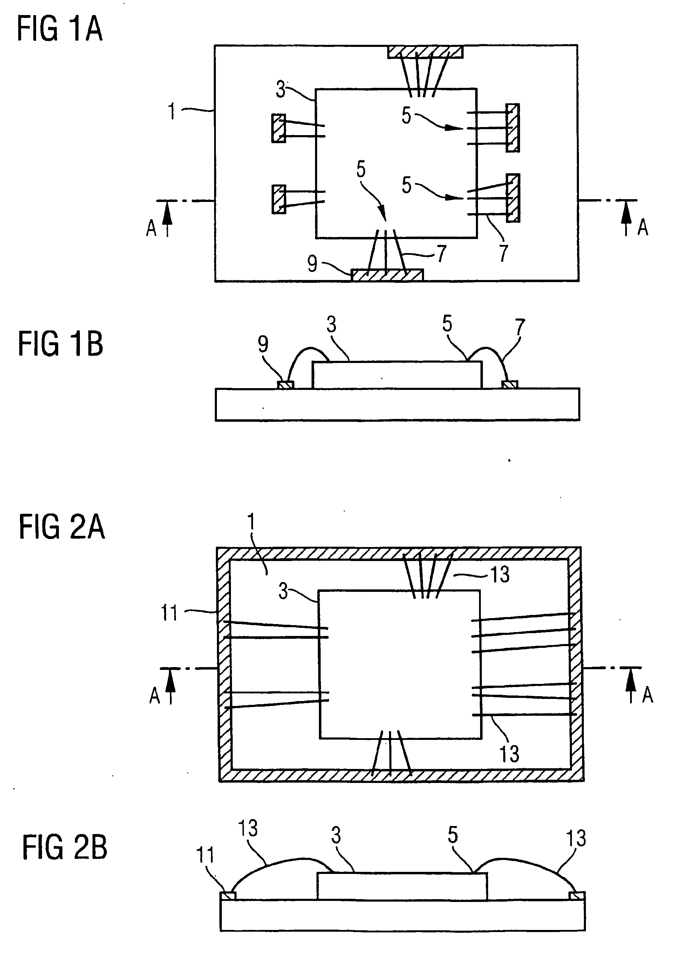

A known packaging method is illustrated in Fig. 1, which consists of Figs. 1(a) and 1(b). Fig. 1 (a) is a top of a central portion 1 of a lead frame, while Fig. 1(b) is a cross-sectional view in the line A-A. The central portion 1 of the lead frame is made of a conductive material. For example, it may be a copper plate. The lead frame includes further portions (not shown) outside the region 1, including leads. An integrated circuit 3 is adhered on a "die pad" area within the portion 1. The integrated circuit 3 includes electrical contacts on its surface which is uppermost in Fig. 1 (b). Certain of these electrical contacts of the chip are bonded by wire bonds (not shown) to respective ones of the leads. However, certain of the contacts 5 of the integrated circuit 3 are to be connected to ground. To do this, the central portion 1 of the lead frame is connected to ground, and wire bonds 7 are formed between respective ones of the contacts 5 and the copper 1. In general, it is found that the adhesion of the wire bonds 7 with the copper 1 is not adequate, and therefore silver regions 9 are plated in the locations of the copper 1 where the wire bonds 7 terminate. Subsequently, the integrated circuit 3, wire bonds 7 and silver plated regions 9 are encased in resin. During the same resin moulding process, the wire bonds (not shown) between the integrated circuit 3 and the leads (not shown) are encased in a resin body.

This process suffers from a number of problems. A first is that, in subsequent use of the device, the resin body may delaminate from the portion 1 of the lead frame. This delamination propagates rapidly across the surface of the portion 1, and can cause the wires 7 to be torn from the silver plating 9.

A second problem is that, when the integrated circuit 3 is adhered to the portion 1 of the lead frame, the adhesive may leak from beneath the integrated circuit 3 and cover some of the regions of silver plating 9. In this case, it may be impossible to form reliable wire bonds 7 to the regions of silver plating 9.

A third problem is that, since the regions 9 of silver plating are arranged to coincide with the locations of the contacts 5 on the integrated circuit 3, the silver plated lead frame must be designed using knowledge of the integrated circuit 3. In other words, different sorts of lead frames are required for packaging different sorts of integrated circuit 3. This reduces the flexibility of the packaging process. Packaging many sorts of integrated circuit requires a corresponding number of types of lead frame. This problem is addressed by a second known packaging process shown in Fig. 2(a) and 2(b). Elements in these figures which correspond to those of Fig. 1 are shown by the same reference numerals. The process differs from that of Fig. 1 only in that regions 9 are replaced by a ring 11 of silver plating on a laterally outward portion of the portion 1 of the lead frame. The wire bonds 7 of Fig. 1 are replaced by wire bonds 13 between the contacts 5 and the ring 11. Thus, a wide variety of different types of integrated circuit 3 can be packaged with the same type of lead frame. Unfortunately, this arrangement suffers from the problem that, in order that the die pad area is able to accommodate integrated circuits of varying size, the ring 11 is laterally outward compared to the region 9, so when the integrated circuit 3 is relatively small the wires 13 must be much longer than the wires 7 in the arrangement of Fig. 1. Furthermore, adhesion of the resin to the silver plating tends to be less than between the resin and the copper, so the arrangement of Fig. 2, in which a larger proportion of the surface of the portion 1 of the leadframe is covered by silver plating 11, suffers from a higher risk of delamination between the resin and the lead frame.

JP 63202948 relates to a lead frame having protruding sections shaped as close as possible to wire bonding pads. Consequently, wire length can be shortened and the outer leads which act as ground electrodes can be unified with a mount section. The protruding sections are shaped to prevent the flow of solder or adhesives.

US 6585905 discloses a leadless plastic chip carrier comprising a die attach pad, a semiconductor die mounted to a portion of the die attach pad and at least one row of contact pads circumscribing the die attach pad. The row of pads have a greater thickness than portion of the die attach pad. Wire bonds connect the die attach pad and the contact pads.

### Summary of the Invention

The present invention aims to provide new and useful techniques for packaging integrated circuits, and new and useful packaged integrated circuits. In particular, the invention aims to provide integrated circuit packages in which the wires are less liable to lose electrical contact with the central grounded portion of the lead frame.

In general terms, the invention proposes that the central region of the lead frame is selectively etched to leave upstanding portions. Subsequently, during the packaging process, wires are formed between the upstanding portions of the leadframe and the contacts of the integrated circuit which are to be grounded. Subsequently, the wires and upstanding portions of the leadframe are encased in resin.

Since the upstanding portions of the lead frame are encased in resin, the attachment of the resin to the lead frame is much improved. In the first place this is because the area of the lead frame which is in contact with the resin is increased (since it includes the sides of the upstanding portions).

Furthermore, a mechanical locking is provided, so that the attachment of the resin to the lead frame does not have to rely on adhesion between the resin and the copper. This mechanical locking is particularly great if the surfaces of the upstanding portions are concave: a shape which normally arises automatically in the etching process.

Furthermore, any delamination which occurs between the resin and the lead frame cannot propagate easily up the sides of the upstanding portions as far as the wires. Thus, the wires are much less likely to be torn from the lead frame.

Furthermore, even if adhesive leaks from under the integrated circuit when the integrated circuit is mounted on the lead frame, it is most unlikely that it could cover any part of the upper surface of the upstanding portions of the lead frame.

As in known designs, silver is preferably plated onto the upper surface of the upstanding portions of the lead frame.

Specifically, a first expression of the invention is a leadframe in accordance with claim 1.

A second expression of the present invention is a method of forming a lead frame in accordance with claim 4.

Also disclosed is an integrated circuit package provided in accordance with claim 6.

### Brief Description of The Figures

Preferred features of the invention will now be described, for the sake of illustration only, with reference to the following figures in which:
Fig. 1, which is composed of Figs. 1 (a) and 1 (b), illustrates a stage of a first known packaging technique; .
Fig. 2, which is composed of Figs. 2 (a) and 2 (b), illustrates a stage of a second known packaging technique;
Fig. 3, which is composed of Figs. 3 (a) to 3 (c), is three views of a lead frame;
Fig. 4, which is composed of Figs. 4 (a) and 4 (b), shows steps in the formation of the lead frame of Fig. 3;
Fig. 5, which is composed of Figs. 5 (a) and 5 (b), shows steps in a packaging process using the lead frame of Fig. 3;
Fig. 6, which is composed of Figs. 6 (a) to 6 (c) is three views of a lead frame;
Fig. 7, which is composed of Figs. 7 (a) to 7 (h), shows four further lead frames;
Fig. 8, which is composed of Figs. 8 (a) to 8 (d) is four views of a lead frame which is an embodiment of the invention;
Fig. 9, which is composed of Figs. 9 (a) to9 (j) shows five further lead frames which are embodiments of the invention.

### Detailed Description of the embodiments

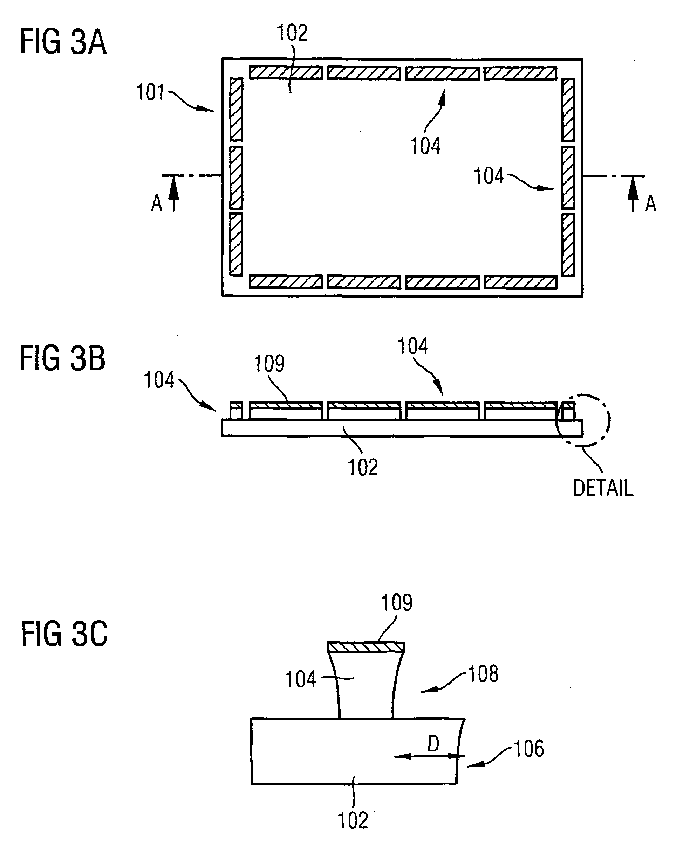

Referring to Fig. 3, a central portion of a lead frame is illustrated. Fig. 3 (a) is a top view, Fig. 3 (b) is a sectional view in the line A-A, and Fig. 3 (c) is an enlarged view of the portion of marked "detail" in Fig. 3 (b). The lead frame has a central portion 101, and further portions (not shown) which are located to the sides of the central portion 101. These further portions of the lead frame are according to conventional designs, and typically include leads which extend in a plane parallel to the major surface of the portion 101. The tips of the leads are for wire bonding to respective contacts of an integrated circuit which is mounted on a die pad region at the centre of the central portion 101 of the lead frame.

Subsequently, in the moulding operation described below, these wire bonds are encased in resin, and then the leads are cut to leave portions of them extending to the sides of the resin portion, or indeed out of it, so that the leads can be connected for further circuitry. All these features may be according to any conventional design.

The central portion 101 of the lead frame is composed of a copper plate 102 and portions 104 upstanding from the plate. The upstanding portions 104 are referred to here as "pedestals". Each of the pedestals 104 has a layer of silver plating 109 on its upper surface. Thus, the silver plating 109, the corresponding pedestal 104 and the copper plate 102 are in electrical contact with each other.

As shown in Fig. 3(c), the pedestal 104 is slightly inward from the edge 106 of the copper plate 102 by a distance "D". The pedestal 104 has concave walls 108.

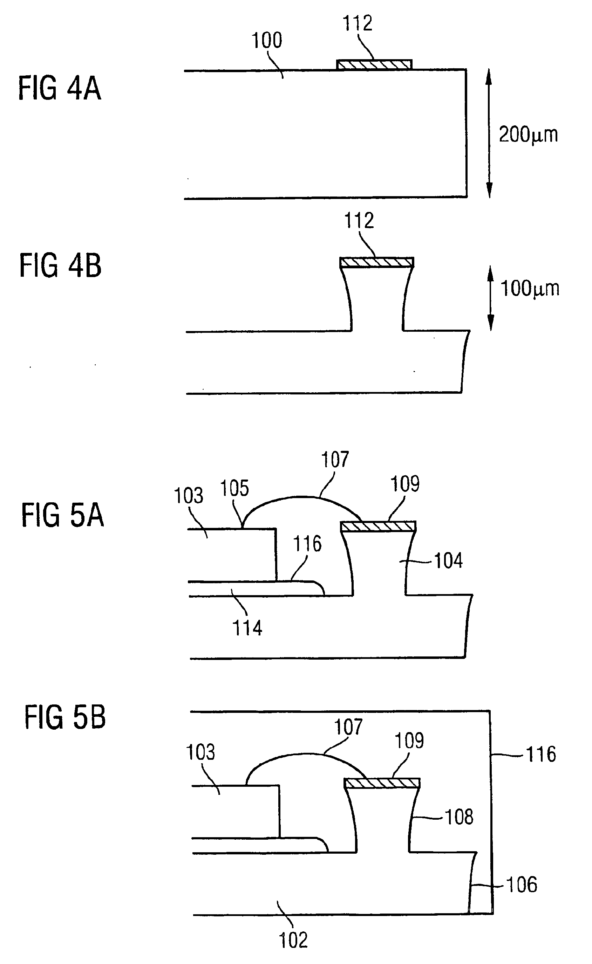

The formation process of the portion 101 of the lead frame is shown in Fig. 4, which, for simplicity, shows only the parts of the structure which will become the structure of Fig. 3(c). To begin with, as shown in Fig. 4(a), a copper plate 110 of thickness of about 200 µm is coated with mask elements 112 (e.g. of a material which is commonly used in this field for masking portions of the lead frame which are to become leads) in locations corresponding to those of the pedestals 104 in the structure of Fig. 3(c). Then the leadframe is etched, removing a top layer of the plate 110 of a thickness about 100 µm. That is, the thickness of the plate 110 is approximately halved. The regions of the plate 110 protected by the mark elements 112 are not etched, and thus the copper underneath them forms pedestals 104 of a height about 100 µm (in other possible forms of the invention the pedestals may have differing heights, but they are typically in the range 50 µm to 150 µm). Thus, the structure of Fig. 4(b) is formed. The mask elements 112 are then removed, and the tops of the pedestals 104 are plated with silver to form the structure of Fig. 3(c). Note that the etching of the plate 110 is typically performed at the same time as a known etching step, performed on the portions of the lead frame which are outward of the central portion 101 of the lead frame, in which the leads are formed.

The use of the lead frame of Fig. 1 is illustrated in Fig. 5. In Fig. 5(a), an integrated circuit 103 is placed on the lead frame, and preferably adhered there. The adhesive layer 114 is lower than tops of the pedestals 104, so even if adhesive 116 leaks out, it cannot reach the tops of the pedestals 104.

The lead frame has certain contacts 105 which are to be connected to ground potential, and wire bonds 107 are formed from these to the silver portions109. This is typically done at the same time as wires are formed between other of the contacts of the integrated circuit and the leads of the lead frame. Then, as shown in Fig. 5 (b), a resin body 116 is moulded, so that the integrated circuit 103, the wire bonds 107 and pedestals 104, are encased in the resin 116. Typically, the wires (not shown) between the other contacts of the integrated circuit 103 and the leads are encased in the same resin body 116 at the same time. The pedestals 104 provide mechanical locking between the resin 116 and the plate 110, especially because of the concave surfaces 108. Further locking is provided by the concave surfaces 106 of the plate 102 produced during the etching. Even if delamination between the resin 116 and plate 102 does occur, it can only propagate easily along the top surface of the plate 102 (i. e. "laterally", that is horizontally as viewed in Fig. 3 (c) ), not up the sides of the pedestals 104. Therefore, there is little chance of the wires 107 being torn from the silver plating 109. Thus, a reliable electrical contact is provided between the contacts 105 and the plate 102, which in use is connected to ground (e. g. attached to a grounded area of a printed circuit board).

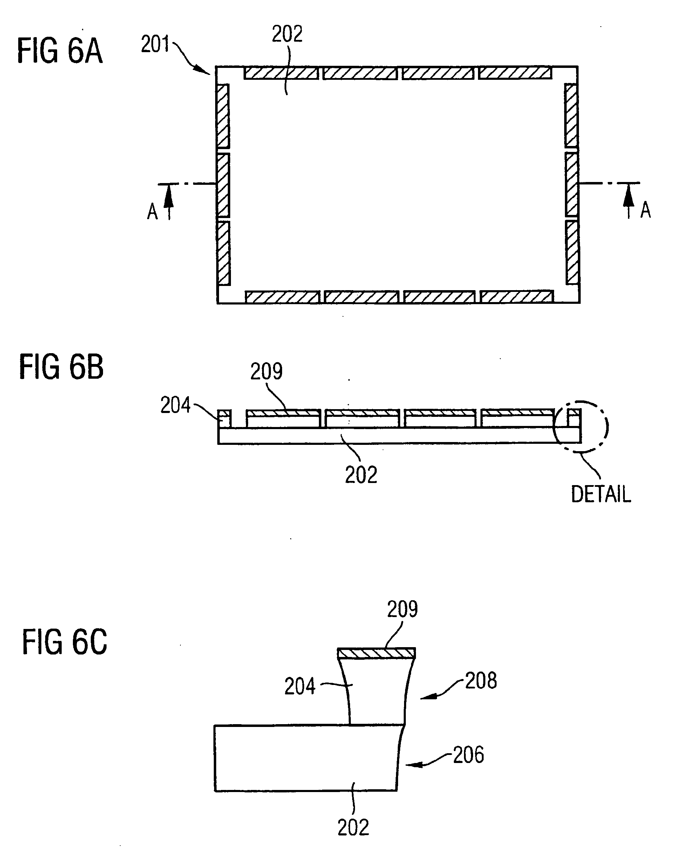

Fig. 6 (a) to 6 (c) are views of a second lead frame 201. Elements of the lead frame 201 corresponding to those of the lead frame 101 of Fig. 3 are given reference numbers 100 higher. The difference between the lead frames 101 and 201 is that the pedestals 204 extend to the edge 206 of the copper plate 202. The fabrication process, and use, of the central portion of the lead frame 201 is as explained above with reference to Figs. 4 and 5, but with different positions of the mask elements.

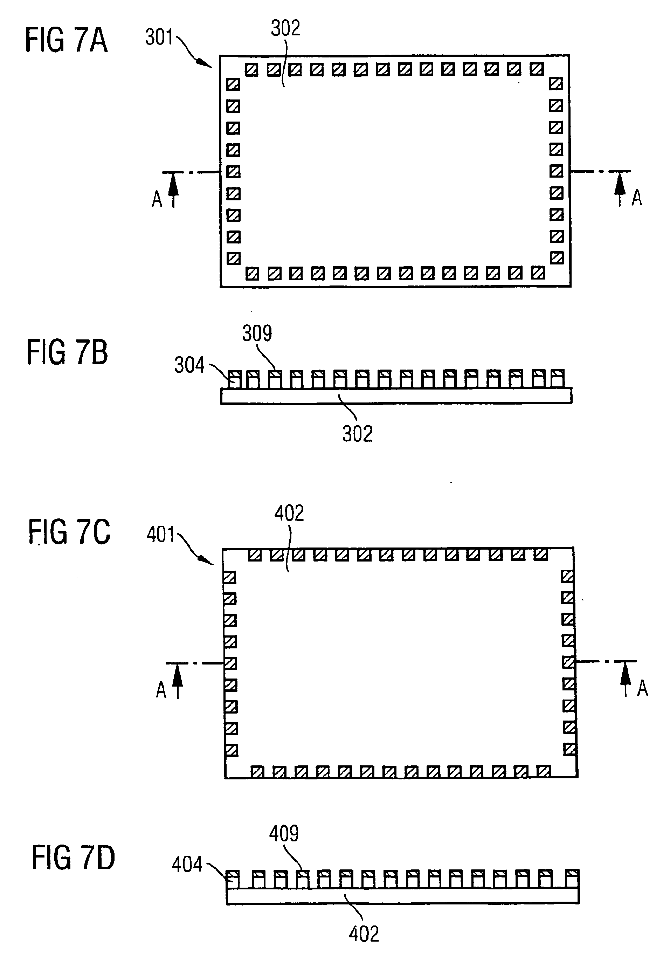

Figs. 7 (a) and 7 (b) are views of a third lead frame 301. Elements of the lead frame 301 corresponding to those of the lead frame 101 of Fig. 3 are given reference numbers 200 higher. The pedestals 304 are much shorter than the pedestals 104,204 in the direction along the corresponding side of the copper plate 310. This can improve the mechanical interlocking of the resin body and the lead frame 301.

Figs. 7 (c) and 7 (d) are views of a fourth lead frame 401. Elements of the lead frame 401 corresponding to those of the lead frame 101 of Fig. 3 are given reference numbers 300 higher.

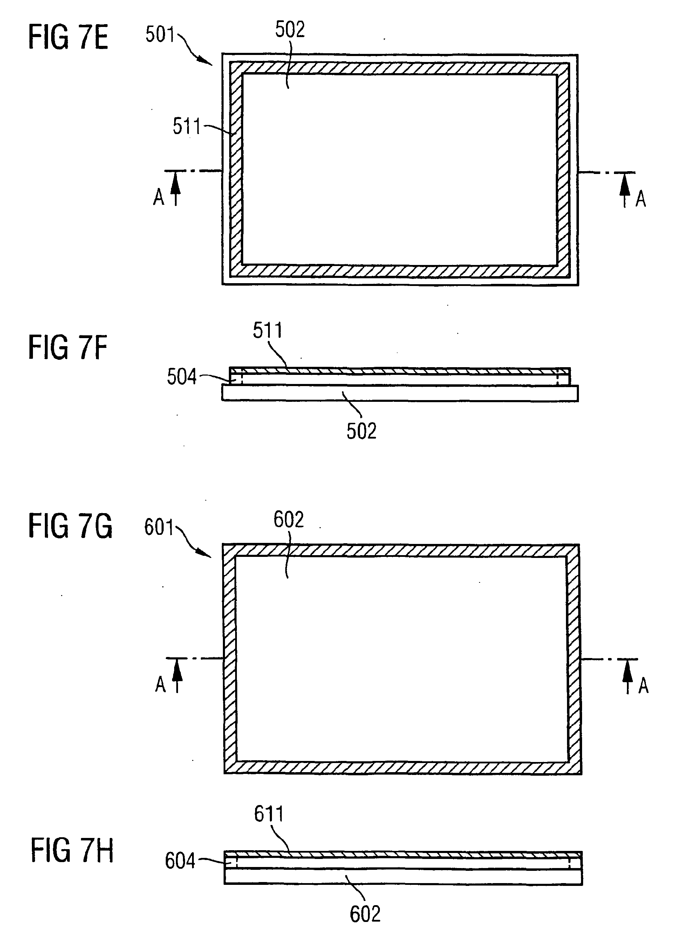

Figs. 7 (e) and 7 (f) are views of a fifth lead frame 501. Elements of the lead frame 501 corresponding to those of the lead frame 101 of Fig. 3 are given reference numbers 400 higher. In this case the pedestals 104 of Fig. 3 are replaced by a single pedestal 504 encircling the central portion of the plate 302 which is to receive the die. The top surface of the pedestal 504 is plated with silver 511, and thus forms a ring analogous to the ring 11 of Fig. 2. Compared to the first to fourth embodiments of the invention, the lead frame 501 is more flexible, in the sense that during the packaging wires can be formed from the contacts of the integrated circuit which are to be grounded to any locations along the sides of the central portion of the lead frame 501, whereas when providing wire bonds to the pedestals 104,204, 304,404 it is necessary to ensure that the wires extend to the correct locations along the sides of the central portion of the lead frame.

The fabrication process, and use, of the central portion of the lead frame 701 is as explained above with reference to Figs. 4 and 5, but with different positions of the mask elements.

Figs. 7 (g) and 7 (h) are views of a central portion of a sixth lead frame 601. Elements of the lead frame 601 corresponding to those of the lead frame 501 are given reference numbers 100 higher. In this case, the ring 611 is located at the outer edge of the plate 602.

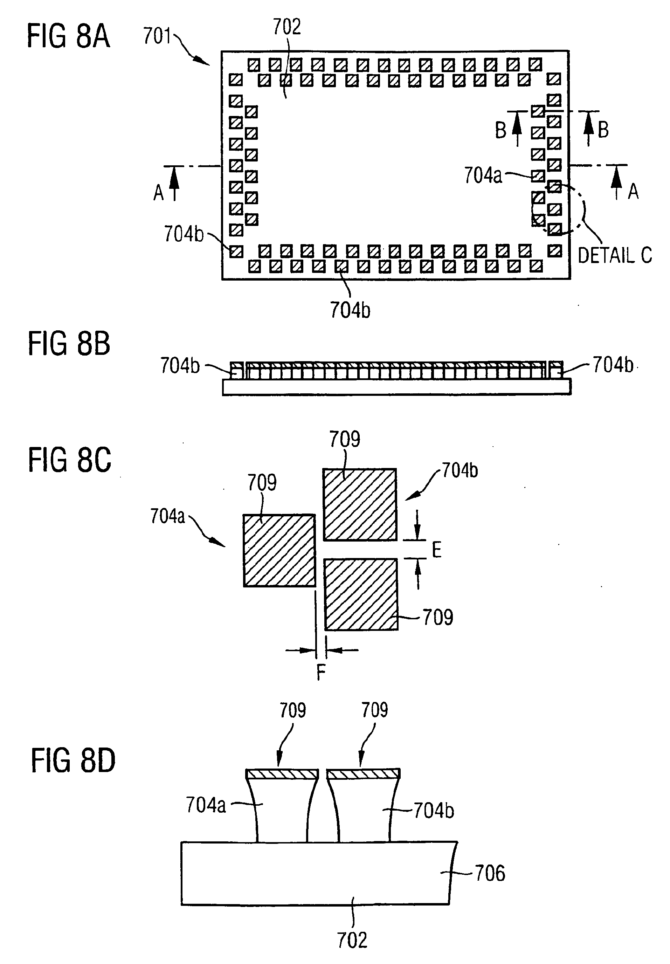

Figs. 8 (a) to 8 (d) are four views of part of a seventh lead frame 701 according to the invention. Fig. 8 (a) is a top view. Fig. 8 (b) is a sectional view in the line A-A on Fig. 8(a). Fig. 8(c) is a sectional view of the portion of the lead frame 701 marked as "detail C" in Fig. 8(a), and Fig. 8(d) is a sectional view in the line B-B in Fig. 8(a). The lead frame 701 resembles the lead frame 301 of Fig. 7(a), so elements of Fig. 8 corresponding to those of Fig. 7(a) are labelled by reference numerals 400 higher. In contrast to the lead frame 301, the lead frame 701 has pedestals 704a, 704b along each side of the central portion in two groups. A first group of pedestals 704b are displaced by a first distance from the edge 706 of the central portion, while a second group of pedestals 704a are displaced inwardly from the edge 706 by a greater distance. There is a distance E between pairs of the pedestals 704a, and between pairs of the pedestals 704b, and a distance F between the groups 704a and 704b. Dimensions E and F may each be in the range 10 to 100 µm.

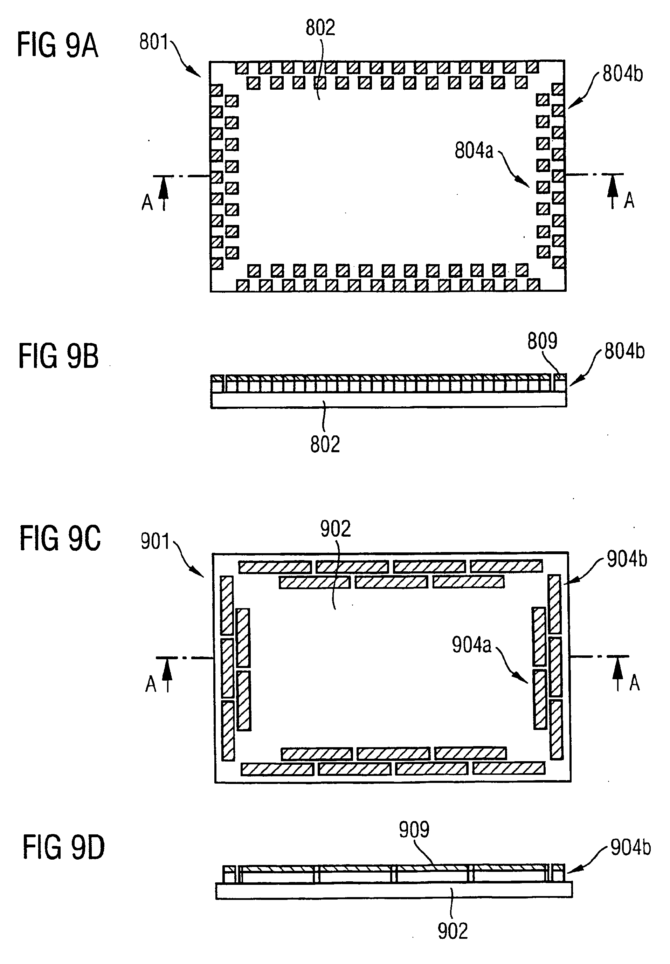

Figs. 9(a) and 9(b) are views of a central portion of a eighth lead frame 801 according to the invention. Fig. 9(b) is a view in the direction shown as A-A in Fig. 9(a). The lead frame 801 resembles the lead frame 401, but includes pedestals 804a which are spaced from the edge of the plate 802, and pedestals 804b which extend to the edges of the plate 802. Elements of the lead frame 801 corresponding to those of the lead frame 401 are given reference numbers 400 higher.

Figs. 9(c) and 9(d) are views of a central portion of a ninth lead frame 901 according to the invention. Fig. 9(d) is a view in the direction shown as A-A in Fig. 9(c). The lead frame 901 resembles the lead frame 101, but includes pedestals 904a, 904b at two distances from the sides of the lead frame 901. Elements of the lead frame 901 corresponding to those of the lead frame 101 are given reference numbers 800 higher.

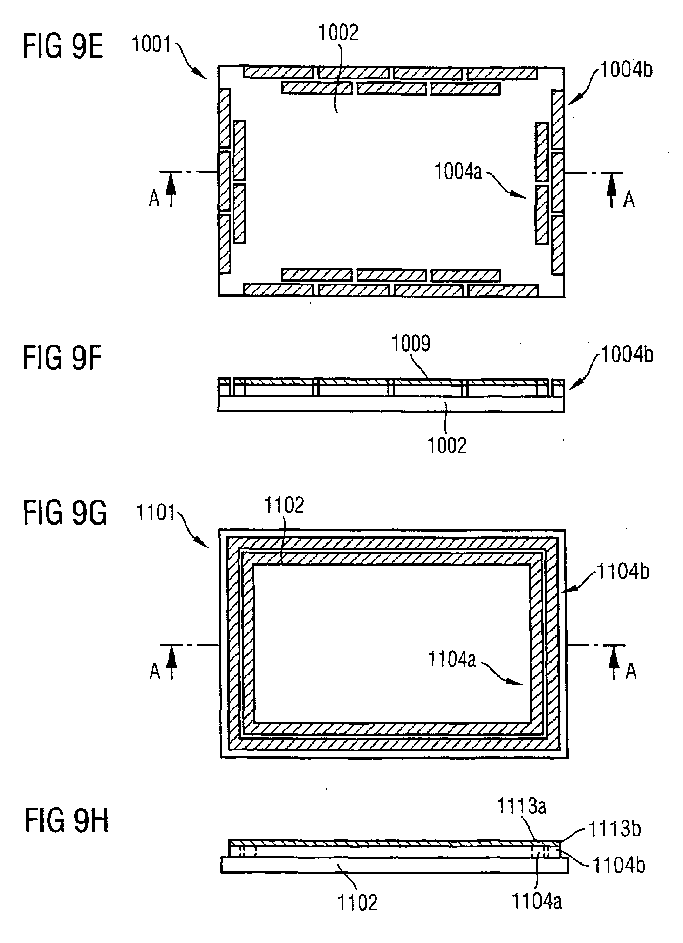

Figs. 9(e) and 9(f) are views of a central portion of a tenth lead frame 1001 according to the invention. Fig. 9(f) is a view in the direction shown as A-A in Fig. 9(e). The lead frame 1001 resembles the lead frame 201, but includes pedestals 1004a, 1004b at two distances from the sides of the lead frame 1001. Elements of the lead frame 1001 corresponding to those of the lead frame 201 are given reference numbers 800 higher.

Figs. 9 (g) and 9 (h) are views of a central portion of an eleventh lead frame 1101 according to the invention. Fig. 9 (h) is a view in the direction shown as A-A in Fig. 9 (g). The lead frame 1101 resembles the lead frame 501, but includes pedestals 1104a, 1104b at two distances from the sides of the lead frame 1101, supporting respective rings 1113a, 1113b. Elements of the lead frame 1101 corresponding to those of the lead frame 501 are given reference numbers 600 higher.

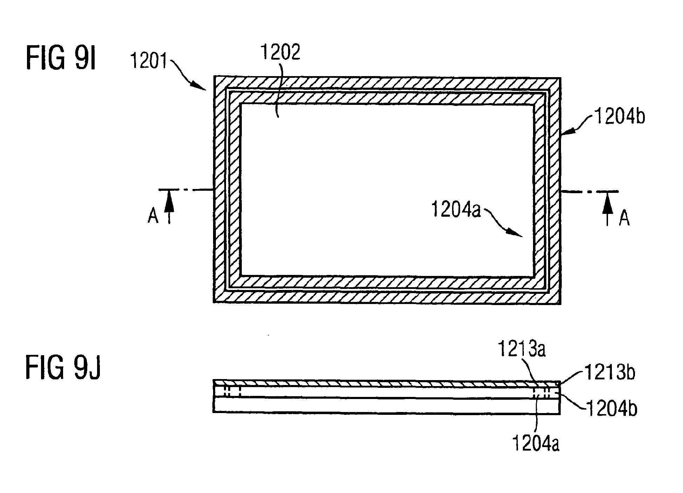

Figs. 9 (i) and9 (j) are views of a central portion of an twelfth lead frame 1201 according to the invention. Fig.9 (j) is a view in the direction shown as A-A in Fig. 9 (i). The lead frame 1201 resembles the lead frame 601, but includes pedestals 1204a, 1204b at two distances from the sides of the lead frame 1201, supporting respective rings 1213a, 1213b. Elements of the lead frame 1201 corresponding to those of the lead frame 601 are given reference numbers 600 higher.

Although only some embodiments of the invention have been described above in detail, many variations are possible within the scope of the invention as will be clear to a skilled reader.

## Claims

1. A leadframe (701, 801, 901, 1001, 1101, 1201) for packaging an integrated circuit, the leadframe (701, 801, 901, 1001, 1101, 1201) including:
a central portion which is formed of conductive material and which includes a die pad area for attachment of an integrated circuit, the central portion of the lead frame including a plurality of upstanding portions in electrical contact with the die pad area and adapted for wire-bond attachment to contacts of an integrated circuit which are to be grounded,
**characterized in that** the upstanding portions are first and second upstanding portions (1104a, 1104b, 1204a, 1204b) each encircling continuously the central portion, the second upstanding portion (1104a, 1204a) being displaced inwardly from the edge of the central portion by a greater distance than the first upstanding portion (1104b, 1204b), or
the upstanding portions are a first group of upstanding portions (704b, 804b, 904b, 1004b) being displaced by a first distance from an edge of the central portion and a second group of upstanding portions (704a, 804a, 904a, 1004a) being displaced inwardly from the edge by a second, greater distance and wherein the upstanding portions (704a, 704b, 804a, 804b, 904a, 904b, 1004a, 1004b) are provided along each side of the central portion;
wherein side surfaces of the upstanding portions (704a, 704b,... 1204a, 1204b) are concave.

2. A leadframe (701, 801, 901, 1001, 1101, 1201) according to claim 1 in which the upper (701, 801, 901, 1001, 1101, 1201) surfaces of the upstanding portions (704a, 704b,... 1204a, 1204b) of the lead frame are plated with silver.

3. A leadframe (701, 801, 901, 1001, 1101, 1201) according to claim 1 in which the first group of upstanding portions (704b, 804b, 904b, 1004b) or the first upstanding portion (1104b, 1204b) is located at, or proximate to, one of the lateral sides of the central plate portion of the lead frame.

4. A method of forming a lead frame (701, 801, 901, 1001, 1101, 1201) according to any one of claims 1 to 3, the method including:
selectively etching one surface of the central conductive portion of the lead frame (701, 801, 901, 1001, 1101, 1201) to form the plurality of upstanding portions (704a, 704b,... 1204a, 1204b); and
providing a layer of a conductive material (709, 809, 909, 1009, 1109, 1209) onto the top surfaces of the upstanding portions (704a, 704b,... 1204a, 1204b).

5. A method of packaging an integrated circuit including:
locating an integrated circuit on the die pad area of a leadframe (701, 801, 901, 1001, 1101, 1201) according to any of claims 1 to 3;
forming wires between one or more electrical contacts of the integrated circuit and the upstanding portions (704a, 704b,... 1204a, 1204b) of the lead frame (701, 801, 901, 1001, 1101, 1201), and
encapsulating the integrated circuit, wires and the upstanding portions of the lead frame in a resin body.

6. An integrated circuit package including:
an integrated circuit located at a die pad portion of a leadframe (701, 801, 901, 1001, 1101, 1201) according to any of claims 1 to 3:
wire bonds between at least one electrical contact of the integrated circuit and a respective one of the upstanding portions (704a, 704b,... 1204a, 1204b); and
a resin body encapsulating the wire bonds.

## Patentansprüche

1. Systemträger (701, 801, 901, 1001, 1101, 1201) zur Montage einer integrierten Schaltung, wobei der Systemträger (701, 801, 901, 1001, 1101, 1201) aufweist:
einen zentralen Abschnitt, der aus einem leitenden Material besteht und der einen Chipkontaktbereich zum Anschluss einer integrierten Schaltung aufweist, wobei der zentrale Abschnitt des Systemträgers eine Vielzahl von aufrecht stehenden Abschnitten in elektrischem Kontakt mit der Chipkontaktbereich aufweist und zum Anschluss an Kontakte einer integrierten Schaltung, die zu erden sind, durch Drahtbonden eingerichtet ist,
**dadurch gekennzeichnet, dass** die aufrecht stehenden Abschnitte erste und zweite aufrecht stehende Abschnitte (1104a, 1104b, 1204A, 1204b) sind, die jeweils den zentralen Abschnitt kontinuierlich umgeben, wobei der zweite aufrecht stehende Abschnitt (1104a, 1204A) vom Rand des zentralen Abschnitts um einen größeren Abstand nach innen verschoben ist als der erste aufrecht stehende Abschnitt (1104b, 1204b), oder
die aufrecht stehenden Abschnitte Folgende sind: eine erste Gruppe von aufrecht stehenden Abschnitten (704b, 804b, 904B, 1004b), die um einen ersten Abstand von einem Rand des zentralen Abschnitts verschoben sind, und eine zweite Gruppe von aufrecht stehenden Abschnitten (704a, 804a, 904a, 1004a), die um einen zweiten, größeren Abstand vom Rand nach innen verschoben sind, und wobei die aufrecht stehenden Abschnitte (704a, 704b, 804a, 804b, 904a, 904b, 1004a, 1004b) entlang jeder Seite des zentralen Abschnitts vorgesehen sind,
wobei Seitenflächen der aufrecht stehenden Abschnitte (704a, 704b, ... 1204a, 1204b) konkav sind.

2. Systemträger (701, 801, 901, 1001, 1101, 1201) nach Anspruch 1, in dem die oberen (701, 801, 901, 1001, 1101, 1201) Flächen der aufrecht stehenden Abschnitte (704a, 704b, .... 1204a, 1204b) des Systemträgers mit Silber beschichtet sind.

3. Systemträger (701, 801, 901, 1001, 1101, 1201) nach Anspruch 1, in dem die erste Gruppe von aufrecht stehenden Abschnitten (704b, 804b, 904b, 1004b) oder der erste aufrecht stehende Abschnitt (1104b, 1204b) sich an oder sehr nahe an einer der Längsseiten des zentralen Plattenabschnitts des Systemträgers befindet.

4. Verfahren zur Herstellung eines Systemträger (701, 801, 901, 1001, 1101, 1201) nach einem der Ansprüche 1 bis 3, wobei das Verfahren aufweist:
selektives Ätzen einer Fläche des zentralen leitenden Abschnitts des Systemträgers (701, 801, 901, 1001, 1101, 1201) zur Ausbildung der Vielzahl von aufrecht stehenden Abschnitten (704a, 704b, ... 1204a, 1204b); und
Bereitstellen einer Schicht eines leitenden Materials (709, 809, 909, 1009, 1109, 1209) auf den oberen Flächen der aufrecht stehenden Abschnitte (704a, 704b, ... 1204a, 1204b).

5. Verfahren zur Montage einer integrierten Schaltung mit den Schritten:
Anordnet einer integrierten Schaltung auf dem Chipkontaktbereich eines Systemträgers (701 801, 901, 1001, 1101, 1201) nach einem der Ansprüche 1 bis 3;
Ausbilden von Drähten zwischen einem oder mehreren elektrischen Kontakten der integrierten Schaltung und den aufrecht stehenden Abschnitten (704a, 704b, ... 1204a, 1204b) des Systemträgers (701, 801, 901, 1001, 1101, 1201) und
Einkapseln der integrierten Schaltung, der Drähte und der aufrecht stehenden Abschnitte des Systemträgers in einem Harzkörper.

6. Integriertes Schaltungsgehäuse mit:
einer integrierten Schaltung, die sich auf einem Chipkontaktabschnitt eines Systemträgers (701, 801, 901, 1001, 1101, 1201) nach einem der Ansprüche 1 bis 3 befindet;
Drahtbondverbindungen zwischen mindestens einem elektrischen Kontakt der integrierten Schaltung und einem entsprechenden der aufrecht stehenden Abschnitte (704a, 704b, ... 1204a, 1204b); und
einem Harzkörper, der die Drahtbondverbindungen einkapselt.

## Revendications

1. Grille de connexion (701, 801, 901, 1001, 1101, 1201) pour conditionner un circuit intégré, la grille de connexion (701, 801, 901, 1001, 1101, 1201) comprenant :
une partie centrale qui est constituée d'un matériau conducteur et qui comprend une zone de pastilles de puce pour la fixation d'un circuit intégré, la partie centrale de la grille de connexion comprenant une pluralité de parties dressées en contact électrique avec la zone de pastilles de puce et conçues pour une fixation par liaison par fils aux contacts d'un circuit intégré qui doivent être mis à la masse,
**caractérisée en ce que** les parties dressées sont des première et deuxième parties dressées (1104a, 1104b, 1204a, 1204b) encerclant chacune de façon continue la partie centrale, la deuxième partie dressée (1104a, 1204a) étant décalée vers l'intérieur par rapport au bord de la partie centrale d'une plus grande distance que la première partie dressée (1104b, 1204b), ou
les parties dressées sont un premier groupe de parties dressées (704b, 804b, 904b, 1004b) qui sont décalées d'une première distance par rapport à un bord de la partie centrale et un deuxième groupe de parties dressées (704a, 804a, 904a, 1004a) qui sont décalées vers l'intérieur par rapport au bord d'une deuxième distance plus grande, et dans laquelle les parties dressées (704a, 704b, 804a, 804b, 904a, 904b, 1004a, 1004b) sont prévues le long de chaque côté de la partie centrale,
dans laquelle les surfaces latérales des parties dressées (704a, 704b, ... 1204a, 1204b) sont concaves.

2. Grille de connexion (701, 801, 901, 1001, 1101, 1201) selon la revendication 1, dans laquelle les surfaces supérieures (701, 801, 901, 1001, 1101, 1201) des parties dressées (704a, 704b, ... 1204a, 1204b) de la grille de connexion sont revêtues d'argent.

3. Grille de connexion (701, 801, 901, 1001, 1101, 1201) selon la revendication 1, dans laquelle le premier groupe de parties dressées (704b, 804b, 904b, 1004b) ou la première partie dressée (1104b, 1204b) est situé au niveau, ou à proximité de l'un des côtés latéraux de la partie formant plaque centrale de la grille de connexion.

4. Procédé de formation d'une grille de connexion (701, 801, 901, 1001, 1101, 1201) selon l'une quelconque des revendications 1 à 3, le procédé consistant à :
graver de manière sélective une surface de la partie conductrice centrale de la grille de connexion (701, 801, 901, 1001, 1101, 1201) pour former la pluralité de parties dressées (704a, 704b, ... 1204a, 1204b) ; et
fournir une couche d'un matériau conducteur (709, 809, 909, 1009, 1109, 1209) sur les surfaces supérieures des parties dressées (704a, 704b, ... 1204a, 1204b).

5. Procédé de conditionnement d'un circuit intégré consistant à :
positionner un circuit intégré sur la zone de pastilles de puce d'une grille de connexion (701, 801, 901, 1001, 1101, 1201) selon l'une quelconque des revendications 1 à 3 ;
former des fils entre un ou plusieurs contacts électriques du circuit intégré et les parties dressées (704a, 704b, ... 1204a, 1204b) de la grille de connexion (701, 801, 901, 1001, 1101, 1201) ; et
encapsuler le circuit intégré, les fils et les parties dressées de la grille de connexion dans un corps en résine.

6. Boîtier de circuit intégré comprenant :
un circuit intégré situé au niveau d'une partie de pastilles de puce d'une grille de connexion (701, 801, 901, 1001, 1101, 1201) selon l'une quelconque des revendications 1 à 3 ;
des liaisons par fils entre au moins un contact électrique du circuit intégré et une partie respective parmi les parties dressées (704a, 704b, ... 1204a, 1204b) ; et
un corps en résine encapsulant les fils de liaison.
